# DEMANDE DE BREVET EUROPEEN

(11) **EP 4 675 923 A1**
(43) Date de publication de la demande: **07.01.2026**
(21) Numéro de dépôt: 25186376.7
(22) Date de dépôt: 30.06.2025
(51) Int. Cl.: H03K 17/12, H03K 17/14, H03K 17/082

(54) **DISPOSITIF A BRANCHES PARALLELES**

(30) Priorité: 01.07.2024 FR 2407161
(71) Demandeur: Commissariat à l'Energie Atomique et aux Energies Alternatives, 75015 Paris (FR)
(72) Inventeur: PEREZ, Gaëtan, 38054 GRENOBLE CEDEX 09 (FR); STERNA, Léo, 38054 GRENOBLE CEDEX 09 (FR)
(74) Mandataire: Cabinet Beaumont

(57) **Abrégé**

Un dispositif (DEV2) comprend des branches (B1, B2, B3) identiques en parallèle ayant chacune un composant semiconducteur (T1, T2, T3) commandé à l'état passant par un premier état d'un signal de commande (cmd1, cmd2, cmd3) et à l'état bloqué par un deuxième état du signal de commande. Une résistance du composant a un coefficient négatif de variation avec la température. Dans chaque branche, un circuit mesure (MES1, MES2, MES3) une valeur (val1, val2, val3) d'un paramètre. Un circuit de commande (CTRL2) reçoit une indication d'une ou plusieurs durées d'état passant (D) et les valeurs mesurées, et, pendant chaque durée d'état passant (D), fournit le signal de commande à chaque branche dans le premier état pendant une durée modulée par rapport à la durée d'état passant pour garder la valeur du paramètre dans une même plage de valeurs pour toutes les branches.

## Description

### Domaine technique

La présente description concerne de façon générale les circuits électroniques, et, plus particulièrement les circuits électroniques comprenant plusieurs branches parallèles identiques ayant chacune un composant semiconducteur avec une résistance à l'état passant diminuant avec la température.

### Technique antérieure

Dans de nombreux systèmes électroniques connus, plusieurs composants semiconducteurs identiques sont connectés en parallèle, chaque composant semiconducteur étant mis en œuvre à partir d'un matériau semiconducteur, par exemple dans et sur une portion de couche de ce matériau semiconducteur.

La prévision de plusieurs composants semiconducteurs identiques en parallèle permet, par exemple, d'augmenter la quantité maximale de courant qui peut circuler dans ces composants en parallèle sans augmenter les dimensions des composants semiconducteurs identiques. Par exemple, la taille d'une puce semiconductrice est limitée par la technologie de fabrication des composants semiconducteurs de cette puce, et il peut être compliqué, voire impossible, de réaliser des grandes puces en raison, par exemple, des rendements de fabrication limités des tranches de puces semiconductrices ("wafer" en anglais) et/ou de problèmes de tenue mécanique. A titre d'exemple, des convertisseurs de puissance comprennent des transistors mis en œuvre chacun par plusieurs transistors connectés en parallèle.

Dans certains de ces systèmes connus, les composants identiques qui sont connectés en parallèle ont chacun une résistance à l'état passant ayant une valeur qui diminue lorsque la température augmente, ce qui pose divers problèmes.

### Résumé de l'invention

Il existe un besoin de pallier tout ou partie des inconvénients des dispositifs comprenant plusieurs composants semiconducteurs identiques connectés en parallèle et ayant une résistance à l'état passant à coefficient négatif de variation avec la température, c'est à dire une valeur de résistance à l'état passant qui diminue lorsque la température augmente et inversement.

Un mode de réalisation pallie tout ou partie des inconvénients des dispositifs connus décrits ci-dessus.

Un mode de réalisation prévoit un dispositif comprenant deux bornes et des branches identiques connectées en parallèle entre lesdites deux bornes, chaque branche comprenant :
- un composant semiconducteur ayant une borne de commande configurée pour recevoir un signal binaire de commande dans un premier état binaire pour commander l'état passant du composant entre des première et deuxième bornes de conduction du composant et dans un deuxième état binaire pour commander l'état bloqué du composant entre les première et deuxième bornes de conduction du composant, une résistance à l'état passant du composant ayant un coefficient négatif de variation avec la température ;
- un circuit de mesure d'une valeur d'un paramètre de ladite branche,
dans lequel le dispositif comprend en outre un circuit de commande configuré pour :
recevoir un premier signal indiquant une ou plusieurs premières durées pendant lesquelles le dispositif doit être commandé à l'état passant entre ses deux bornes,
recevoir les valeurs mesurées, et
pendant chaque première durée, pour fournir au composant de chaque branche le signal de commande dans le premier état binaire pendant une durée modulée par rapport à la première durée de sorte à maintenir la valeur du paramètre de ladite branche dans une plage de valeurs identique pour toutes les branches.

Selon un mode de réalisation, dans chaque branche, pendant chaque première durée, le circuit de commande est configuré pour que la durée modulée du premier état du signal de commande du composant de la branche soit inférieure ou égale à la première durée.

Selon un mode de réalisation, dans chaque branche, la valeur du paramètre est au moins en partie déterminée par la résistance à l'état passant du composant de ladite branche.

Selon un mode de réalisation, dans chaque branche, le composant semiconducteur est en série avec au moins un autre élément, par exemple une résistance.

Selon un mode de réalisation, chaque branche comprend uniquement ledit composant et le circuit de mesure.

Selon un mode de réalisation, le circuit de commande est configuré, pour chaque branche, pendant chaque première durée, pour moduler la durée du premier état du signal de commande de la branche indépendamment par rapport aux signaux de commande des autres branches.

Selon un mode de réalisation, le circuit de commande est configuré, pour chaque branche, et pendant chaque première durée, pour diminuer la durée du premier état du signal de commande de la branche par rapport à la première durée lorsque la valeur du paramètre mesurée pour cette branche est représentative d'une diminution de la résistance à l'état passant du composant.

Selon un mode de réalisation, ledit paramètre est un courant circulant dans la branche, entre les bornes de conduction du composant de la branche, ou une température de ladite branche.

Selon un mode de réalisation, le semiconducteur est du diamant.

Selon un mode de réalisation, le composant est un transistor MOS.

Selon un mode de réalisation, le circuit de commande est configuré, à chaque première durée, pour que, dans chaque branche d'un sous-ensemble desdites branches, le composant de ladite branche soit commandé à l'état passant pendant exactement ladite première durée.

Selon un mode de réalisation, le circuit de commande est configuré, pendant chaque première durée, et pour chaque branche, pour moduler la durée du premier état du signal de commande du composant de la branche en forçant périodiquement le deuxième état du signal de commande pendant une deuxième durée, de préférence selon une modulation en largeur d'impulsion.

Selon un mode de réalisation, le circuit de commande est configuré, pendant chaque première durée, et pour chaque branche, pour moduler la durée du premier état du signal de commande du composant de la branche en forçant le deuxième état du signal de commande pendant une deuxième durée débutant avec la première durée et/ou en forçant le deuxième état du signal de commande pendant une troisième durée se terminant avec la première durée.

Un autre mode de réalisation prévoit un système électronique comprenant un dispositif tel que décrit ci-dessus, dans lequel lesdites branches mettent en œuvre, entre lesdites deux bornes, un interrupteur du système.

Un autre mode de réalisation prévoit un onduleur comprenant tel que décrit ci-dessus, dans lequel :
le dispositif met en œuvre un interrupteur de commutation de l'onduleur ;
dans chaque branche, le composant est un interrupteur configuré pour être bidirectionnel en courant à l'état passant et pour laisser passer un courant positif uniquement depuis une première borne de conduction du composant vers une deuxième borne de conduction du composant à l'état bloqué ;
le premier signal indique une pluralité de premières durées; et
le circuit de commande est configuré, pendant chaque première durée, et pour chaque branche, pour que la deuxième durée et/ou la troisième durée soient non nulles, uniquement si un courant circulant entre les deux bornes est un courant positif circulant depuis les premières bornes de conduction des composants vers les deuxièmes bornes de conduction des composants.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un exemple d'un dispositif à branches en parallèle comprenant chacune un composant semiconducteur avec une résistance à l'état passant une valeur qui diminue lorsque la température augmente ;
la figure 2 représente un exemple de mode de réalisation d'un dispositif à branches en parallèle comprenant chacune un composant semiconducteur avec une résistance à l'état passant une valeur qui diminue lorsque la température augmente ;
la figure 3 représente un exemple de mode de commande de composants semiconducteurs dans un dispositif du type de celui de la figure 2 ;
la figure 4 représente, de manière plus détaillée, le mode de commande de la figure 3 ;
la figure 5 représente un exemple d'un autre mode de commande de composants semiconducteurs dans un dispositif du type de celui de la figure 2 ;
la figure 6 représente, de manière plus détaillée, le mode de commande de la figure 5 ; et
la figure 7 représente un exemple d'un mode de réalisation plus détaillé d'un circuit du dispositif de la figure 2.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

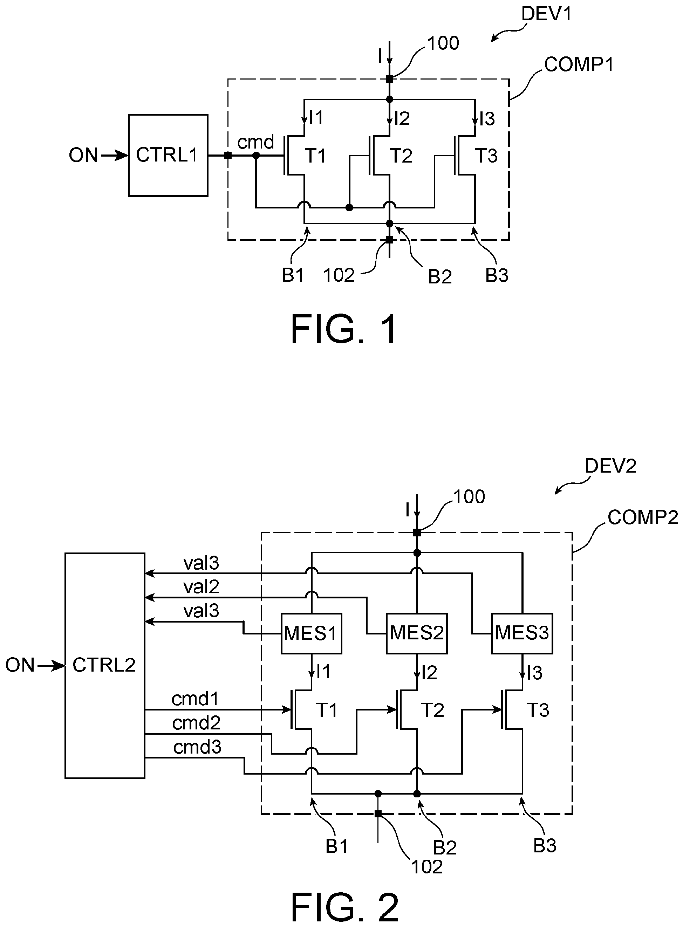

La figure 1 représente un exemple d'un dispositif DEV1 à branches en parallèle comprenant chacune un composant semiconducteur avec une résistance à l'état passant ayant une valeur qui diminue quand la température du composant augmente.

Plus particulièrement, le dispositif électronique DEV1 comprend un composant COMP1 et un circuit CTRL1 configuré pour commander le composant COMP1.

Le composant COMP1 comprend deux bornes 100 et 102 et N branches Bi identiques connectées en parallèle entre les bornes 100 et 102, avec N un nombre entier strictement supérieur à 1 et i un indice entier allant de 1 à N. Le composant COMP1 est configuré pour qu'un courant I circule entre ses bornes 100 et 102.

Dans l'exemple de la figure 1, N est égal à 3 et le dispositif DEV1 comprend trois branches B1, B2 et B3 identiques connectées en parallèle entre les bornes 100 et 102. Par exemple, chaque branche Bi a une extrémité connectée à la borne 100 et une autre extrémité connectée à la borne 102.

Chaque branche Bi comprend un composant semiconducteur Ti (T1, T2 et T3 en figure 1), c'est à dire un composant formé dans et/ou sur une portion de couche semiconductrice, par exemple, faite de diamant. Comme les branches Bi sont identiques entre elles, les composants Ti sont identiques entre eux aux dispersions de fabrication près.

Chaque composant Ti comprend deux bornes de conduction et une borne de commande configurée pour recevoir un signal de commande, par exemple une tension ou un courant de commande. L'état passant ou bloqué de chaque composant Ti est déterminé par le signal de commande reçu sur la borne de commande de ce composant. En outre, lorsque le composant Ti est commandé à l'état passant, la valeur du signal de commande détermine une valeur de résistance à l'état passant du composant Ti entre ses deux bornes de conduction.

Par exemple, le signal de commande reçu par chaque composant Ti sur sa borne de commande est un signal binaire ayant un premier état, correspondant par exemple à un premier niveau de tension, commandant l'état passant du composant, et ayant un deuxième état, correspondant par exemple à un deuxième niveau de tension, commandant l'état bloqué du composant. Par exemple, une modification de la valeur du premier niveau du signal de commande permet de modifier la valeur de résistance à l'état passant du composant Ti recevant ce signal de commande.

Par exemple, l'une des deux bornes de conduction de chaque composant Ti est couplée, par exemple connectée, à la borne 100, l'autre des deux bornes de conduction de chaque composant Ti étant couplée, par exemple connectée, à la borne 102. Chaque composant Ti est configuré, à l'état passant, pour qu'un courant Ii (I1, I2 et I3 en figure 1) circulant dans la branche Bi circule entre les deux bornes de conduction du composant Ti.

Dans l'exemple de la figure 1, les branches Bi reçoivent toutes un même signal de commande cmd, commun à toutes les branches Bi. Dit autrement, tous les composants Ti reçoivent le signal cmd sur leurs bornes de commande respectives. Cette commande, par un seul et même signal de commande appliqué à toutes les branches Bi, est la commande usuellement utilisée dans les dispositifs à N branches Bi parallèles et identiques. Par exemple, en figure 1, le signal cmd est fourni à la borne de commande de chacun des composants T1, T2 et T3. A titre d'exemple, lorsque le signal cmd commande un état passant des composants Ti, la valeur du signal cmd détermine la valeur de la résistance à l'état passant de chacun des composants Ti.

Le signal de commande cmd est fourni par le circuit de commande CTRL1 du dispositif DEV1. Par exemple, le circuit CTRL1 reçoit un signal ON. Le signal ON indique au circuit CTRL1 au moins une durée (ou période) D pendant laquelle les composants Ti doivent être contrôlés à l'état passant. Dit autrement, le signal ON indique au circuit CTRL1 au moins une durée D pendant laquelle le composant COMP1, ou le dispositif DEV1, doit être à l'état passant entre ses bornes 100 et 102. Dit encore autrement, le signal ON indique au circuit CTRL1 au moins une durée D pendant laquelle la connexion en parallèle des branches Bi doit être passante. Par exemple, le signal ON indique au circuit CRTL1 une alternance de durées D et de durées D', chaque durée (ou période) D correspondant à une commande des composants Ti à l'état passant, et chaque durée D' correspondant à une commandes de composants Ti à l'état bloqué. Lorsque le signal ON indique au circuit CTRL1 plusieurs durées D, celles-ci peuvent avoir des valeurs différentes. A titre d'exemple, le signal ON est un signal binaire ayant un premier état indiquant au circuit CTRL1 que les composants Ti doivent être contrôlés à l'état passant, et un deuxième état indiquant au circuit CTRL1 que le composants Ti doivent être commandés à l'état bloqué.

La topologie du circuit DEV1 de la figure 1 avec une commande commune (le signal cmd) appliquée à tous les composants Ti est celle qui est généralement utilisée dans des dispositifs connus comprenant plusieurs composants Ti devant être commandés pour être sélectivement passants simultanément et bloqués simultanément.

Cette topologie à commande commune est bien adaptée à des composants Ti identiques ayant une résistance à l'état passant avec un coefficient positif de variation avec la température, c'est à dire que la valeur de la résistance à l'état passant du composant Ti augmente quand la température augmente, et, à l'inverse, diminue quand la température diminue. En effet, les pertes par conduction dans chaque composant Ti sont de type Roni*Ii², avec Roni la résistance à l'état passant du composant Ti et Ii le courant qui y circule. Ainsi, pour une valeur donnée du signal cmd pour laquelle les composants Ti sont à l'état passant, si la température d'un composant Ti augmente, sa résistance Roni augmente, ce qui entraîne une diminution correspondante du courant Ii y circulant, donc une diminution des pertes par conduction (en raison de la prédominance du carré du courant Ii sur la valeur de résistance Roni). La diminution des pertes par conduction entraîne une diminution de la température dans le composant Ti, donc une diminution de la résistance Roni et ainsi de suite. La résistance Roni garde donc une valeur de résistance sensiblement constante et déterminée par la valeur du signal cmd lorsque ce signal est dans son premier état.

En revanche, cette topologie à commande commune n'est pas adaptée à des composants Ti ayant une résistance à l'état passant avec un coefficient négatif de variation avec la température, c'est à dire que la valeur de la résistance à l'état passant du composant Ti diminue quand la température augmente, et, à l'inverse, augmente quand la température diminue.

En effet, bien que les composants Ti soient censés être identiques les uns aux autres, pour une valeur donnée du signal cmd pour laquelle les composants Ti sont à l'état passant, les composants Ti peuvent avoir des valeurs différentes de résistance à l'état passant, par exemple en raison des dispersions de fabrication et/ou de variations de température entre les composants Ti. Il en résulte que l'un des composants Ti a alors une résistance à l'état passant Roni plus faible que celles des autres composants Ti, bien que les composants reçoivent tous le même signal cmd. Le courant Ii dans la branche Bi comprenant le composant Ti le moins résistif est alors plus élevé que le courant Ii dans composants Ti des autres branches, d'où il résulte un échauffement par dissipation thermique plus élevé dans ce composant Ti que dans les composants Ti des autres branches (en raison de la prédominance du carré du courant Ii sur la valeur de résistance Roni). Cet échauffement plus élevé dans ce composant Ti moins résistif entraine une plus grande diminution de la résistance à l'état passant du composant Ti que celles des résistances à l'état passant des composants Ti des autres branches. A son tour, cette plus forte diminution de la résistivité du composant Ti par rapport celles des autres composants entraîne une plus grande augmentation du courant Ii dans ce composant Ti que dans les autres composants Ti, et ainsi de suite. Cela conduit à un vieillissement prématuré de ce composant Ti par rapport aux composants Ti des autres branches, voir à une destruction de ce composant Ti.

Pour pallier l'inconvénient décrit ci-dessus du dispositif DEV1, il est ici proposé de commander indépendamment les composants Ti, c'est à dire de fournir des signaux de commande différents aux composants Ti respectifs, de sorte à optimiser la mise en parallèle des composants Ti.

Plus particulièrement, il est ici proposé de commander chaque composant Ti indépendamment des autres composants Ti, de sorte qu'un paramètre du composant Ti (ou de la branche Bi comprenant ce composant Ti) qui a une valeur dépendante de la résistance à l'état passant du composant Ti, ait une valeur dans une plage de valeurs identique pour tous les composants Ti. Dit autrement, il est ici proposé de commander chaque composant Ti indépendamment des autres composants Ti de sorte que la valeur du paramètre pour ce composant Ti ne s'éloigne pas, ou ne diverge pas, des valeurs de ce paramètre pour les autres composants Ti.

Dans la présente description, sauf indication contraire, l'expression "plage de valeurs" désigne une plage de valeurs s'étendant depuis une valeur minimale jusqu'à une valeur maximale, que les valeurs minimale et maximale soient égales l'une à l'autre (la plage comprenant alors une unique valeur égale aux valeurs minimale et maximale), ou que les valeurs minimale et maximale soient différentes l'une de l'autre (la plage comprenant alors, en plus de ces deux valeurs minimale et maximale, une pluralité de valeurs comprises entre les valeurs minimale et maximale).

Dans la suite de la description, sauf indication contraire, l'expression "paramètre d'une branche Bi" signifie "paramètre du composant Ti de cette branche Bi". Par exemple, lorsque le paramètre est la température, la température de la branche Bi signifie la température du composant Ti de cette branche Bi.

Un mode de réalisation prévoit, dans chaque branche Bi, un circuit de mesure de la valeur du paramètre pour la branche Bi, c'est à dire du paramètre pour le composant Ti de cette branche Bi, et un circuit de commande configuré pour commander chaque composant Ti à partir des valeurs mesurées, de sorte à obtenir le fonctionnement décrit ci-dessus. Par exemple, un mode de réalisation prévoit que chaque composant Ti reçoive un signal de commande cmdi modulé, de manière indépendante pour chaque composant Ti, sur la base des valeurs du paramètre mesurées pour les composants Ti, par exemple sur la base de la valeur du paramètre mesurée pour ce composant Ti.

Par exemple, un mode de réalisation prévoit qu'un circuit de commande soit configuré pour :
recevoir les valeurs du paramètre qui sont mesurées dans chaque branche Bi,
fournir le signal de commande cmdi à chaque composant Ti, et moduler le signal de commande cmdi de chaque composant Ti de sorte à maintenir la valeur du paramètre de chaque branche dans une plage de valeurs identique pour toutes les branches.

Selon un mode de réalisation, le circuit de commande est configuré pour moduler le signal de commande cmdi de chaque composant Ti de sorte à moduler une durée d'état passant du composant Ti, pour maintenir la valeur du paramètre dans la plage de valeurs identique pour toutes les branches. Dit autrement, le circuit de commande est configuré pour moduler le signal de commande cmdi de chaque composant Ti en modulant une durée d'un état du signal de commande cmdi correspondant à l'état passant du composant Ti, pour maintenir la valeur du paramètre pour ce composant Ti dans la plage de valeurs identique pour toutes les branches.

Selon un mode de réalisation, le circuit de commande reçoit le signal ON décrit en relation avec la figure 1 et les valeurs du paramètre mesurées dans chaque branche. En outre, le circuit de commande fournit les signaux de commande cmdi des composants Ti. Pendant une durée D indiquée par le signal ON, par exemple, pendant chaque durée D indiquée par le signal ON, le circuit de commande fournit au composant Ti de chaque branche Bi le signal de commande cmdi dans le premier état (composant Ti passant) pendant une durée modulée par rapport à cette durée D indiquée par le signal ON. A titre d'exemple, pendant chaque durée D, le circuit de commande force, pour un sous-ensemble des branches Bi comprenant une partie seulement des branches Bi, une modulation nulle de la durée de l'état passant du composant Ti de chaque branche Bi de ce sous-ensemble par rapport à la durée D, de sorte que les composants Ti des branches Bi de ce sous-ensemble soient passants pendant exactement la durée D. De préférence, ce sous-ensemble des branches Bi, qui ne comprend pas toutes les branches Bi, ne comprend qu'une seule branche Bi. A titre d'exemple, lorsque le circuit de commande est configuré pour forcer une modulation nulle dans seulement un sous-ensemble des branches Bi, la ou les branches Bi de ce sous-ensemble sont les mêmes pour toutes les durées D ou peuvent être sélectionnées à chaque durée D en fonction des valeurs du paramètre mesurées dans les branches Bi. A titre d'exemple, le circuit de commande est configuré pour forcer une modulation nulle de la durée d'état passant dans un sous-ensemble des branches Bi lorsque toutes les branches Bi prises ensemble correspondent à, ou mettent en œuvre, un interrupteur d'un convertisseur de tension à découpage et que l'état passant de cet interrupteur est commandé par le signal ON.

La figure 2 représente un exemple de mode de réalisation d'un dispositif DEV2 à branches Bi identiques connectées en parallèle les unes des autres et comprenant chacune un composant semiconducteur Ti à résistance à l'état passant commandable et à coefficient négatif de variation avec la température.

Le dispositif électronique DEV2 comprend un composant COMP2 et un circuit CTRL2 configuré pour commander le composant COMP2.

Le composant COMP2 est similaire au composant COMP1 de la figure 1, et seules les différences entre ces deux composants COMP1 et COMP2 sont ici mises en exergue. Ainsi, sauf indication contraire, tout ce qui a été indiqué pour le composant COMP1 s'applique au composant COMP2.

Plus particulièrement, le composant COMP2 diffère du composant COMP1 en ce que chaque branche Bi du composant COMP2 comprend un circuit de mesure MESi (MES1, MES2 et MES3 dans l'exemple de la figure 2 où N est égal à 3).

Dans chaque branche Bi, le circuit MESi est configuré pour mesurer une valeur d'un paramètre de la branche Bi. Par exemple, ce paramètre a une valeur qui dépend, au moins en partie, de la résistance à l'état passant du composant Ti de la branche Bi, par exemple qui augmente quand la résistance à l'état passant diminue bien que l'inverse soit également possible. Chaque circuit MESi fournit un signal vali (val1, val2 et val3 en figure 2) indiquant la valeur mesurée de ce paramètre pour la branche Bi ou le composant Ti correspondant.

Par exemple, le paramètre mesuré dans chaque branche est le courant Ii circulant dans la branche Bi, et donc dans le composant Ti de la branche Bi, c'est à dire entre les bornes de conduction de ce composant Ti.

A titre d'exemple alternatif, le paramètre mesuré dans chaque branche Bi est la température de la branche Bi, ou, dit autrement, le paramètre mesuré dans chaque branche Bi est la température dans le composant Ti de la branche Bi. En effet, la température du composant Ti de la branche Bi dépend du courant Ii dans la branche Bi et de la valeur de la résistance à l'état passant du composant Ti de la branche.

Dans l'exemple de la figure 2, chaque branche Bi comprend uniquement le composant Ti et le circuit MESi de la branche Bi.

A titre d'exemple, lorsque le paramètre mesuré dans chaque branche Bi est le courant Ii dans la branche Bi, le circuit MESi est connecté en série avec le composant Ti.

Par rapport au dispositif DEV1, le circuit de commande CTRL1 est remplacé par le circuit de commande CTRL2 dans le dispositif DEV2.

Le circuit CTRL2 est configuré pour fournir, au composant Ti de chaque branche Bi, un signal de commande cmdi (cmd1, cmd2 et cmd3 en figure 2) du composant Ti. Par exemple, le signal cmdi est fourni à la borne de commande du composant Ti correspondant. A titre d'exemple, chaque signal cmdi est un signal binaire ayant un premier état commandant un état passant du composant Ti correspondant, et un deuxième état commandant un état bloqué du composant Ti correspondant. Par exemple, le premier état de chaque signal cmdi correspond à un premier niveau de tension, par exemple un niveau haut, et le deuxième état de chaque signal cmdi correspond à un deuxième niveau de tension, par exemple un niveau bas. Dans d'autres exemples, le premier niveau de chaque signal cmdi correspond à un niveau bas et le deuxième état de chaque signal cmdi correspond à un niveau haut. A titre d'exemple, pour chaque signal cmdi, la valeur du signal cmdi lorsque ce signal est dans son premier état détermine la valeur de la résistance à l'état passant du composant Ti correspondant.

Par rapport au circuit CTRL1 qui fournit un même signal cmd à tous les composants Ti, le circuit CTRL2 fournit un signal cmdi distinct à chaque composant Ti, de sorte que chaque composant Ti soit commandé indépendamment des autres composants Ti.

Dans le mode de réalisation de la figure 2, le circuit CTRL2 est configuré pour recevoir le signal ON, comme le circuit CTRL1 de la figure 1. Le signal ON indique au circuit CTRL2 au moins une durée D pendant laquelle le composant COMP2, ou le dispositif DEV2, doit être contrôlé à l'état passant entre ses bornes 100 et 102. Par exemple, le signal ON indique au circuit CRTL2 une alternance de durées D et de durées D', chaque durée D commandant un état passant entre les bornes 100 et 102, et chaque durée D' commandant un état bloqué entre les bornes 100 et 102. Lorsque le signal ON indique au circuit CTRL2 plusieurs durées D, celles-ci peuvent avoir des valeurs différentes. A titre d'exemple, le signal ON est représentatif d'une valeur de rapport cyclique lorsque le composant COMP2 est commandé en modulation de largeur d'impulsion. A titre d'autre exemple, le signal ON indique des instants de début de fin de chaque durée D où le composant COMP2 doit être passant. A titre encore d'autre d'exemple, le signal ON est un signal binaire ayant un premier état indiquant au circuit CTRL2 que le composant COMP2 doit être commandé à l'état passant, et un deuxième état indiquant au circuit CTRL2 que le composant COMP2 doit être commandé à l'état bloqué. A titre d'exemple, dans le cas d'un signal ON binaire, le premier état du signal ON correspond à un premier niveau de tension, par exemple un niveau haut, et le deuxième état du signal ON correspond à un deuxième niveau de tension, par exemple un niveau bas. Dans d'autres exemples, le premier niveau du signal ON correspond à un niveau bas et le deuxième état du signal ON correspond à un niveau haut.

Le circuit CTRL2 reçoit les signaux vali, c'est à dire qu'il reçoit les valeurs mesurées dans les branches Bi du paramètre choisi.

Le circuit CTRL2 est configuré pour éviter que le paramètre de chaque branche Bi ou composant Ti ne prenne des valeurs qui divergent entre les branches Bi, lorsque le composant COMP2 est commandé à l'état passant, c'est à dire pendant une durée D indiquée par le signal ON. Pour cela, pendant cette durée D, le circuit CTRL2 est configuré pour moduler (ou adapter ou déterminer) chaque signal cmdi de sorte que, dans chaque branche Bi, la valeur du paramètre soit maintenue dans une plage de valeurs identiques pour toutes les branches Bi.

Plus particulièrement, selon un mode de réalisation, lorsque le circuit CTRL2 reçoit, via le signal ON, une indication d'une durée D où le composant COMP2 doit être commandé à l'état passant, le circuit CTRL2 fournit, pendant cette durée D, au composant Ti de chaque branche Bi, le signal cmdi correspondant qui est à son premier état (composant Ti passant) pendant une durée modulée par rapport à cette D. La modulation, par le circuit CTRL2, de la durée du premier état de chaque signal cmdi par rapport à la durée D indiquée par le signal ON s'effectue sur la base des valeurs vali mesurées, de sorte à maintenir la valeur du paramètre de chaque branche Bi dans une plage de valeurs identique pour toutes les branches. En pratique, pendant une durée D indiquée par le signal ON, pour chaque signal cmdi, la durée modulée du premier état de ce signal cmdi est inférieure ou égale cette durée D. A titre d'exemple, comme cela a été précédemment indiqué, pendant chaque durée D, le circuit de commande force, pour seulement un sous-ensemble des branches Bi, une modulation nulle de la durée de l'état passant des composants Ti des branches Bi de ce sous-ensemble par rapport à la durée D, de sorte que les composants Ti des branches de ce sous-ensemble soient passants pendant exactement la durée D. A titre d'exemple, le circuit de commande est configuré pour forcer une modulation nulle de la durée d'état passant dans seulement certaines des branches Bi, lorsque composant COMP2 correspond à ou met en œuvre, entre ses bornes 100 et 102, un interrupteur d'un convertisseur de tension à découpage et que l'état passant de cet interrupteur est commandé par le signal ON.

Par exemple, pendant une durée D où le composant COMP2 doit être passant, pour chaque branche Bi, lorsque le signal vali de la branche Bi indique une diminution de la résistance à l'état passant du composant Ti de la branche, le circuit CTRL2 diminue (module à la baisse) la durée du premier état du signal cmdi du composant Ti par rapport à cette durée D, de sorte à augmenter, par exemple en moyenne sur la durée D ou sur une période de temps comprenant une ou plusieurs durées D, la valeur de la résistance à l'état passant du composant Ti, sauf, par exemple, si cette branche Bi correspond à une branche Bi d'un sous-ensemble des branches Bi pour laquelle le circuit CTRL2 force une modulation nulle de la durée du premier état du signal cmdi par rapport à cette durée D. De cette manière, la valeur du paramètre pour la branche Bi, qui dépend de la résistance à l'état passant du composant Ti de la branche, est maintenu dans la plage de valeurs commune aux branches Bi.

A titre d'exemple, le composant Ti de chaque branche Bi est un transistor MOS (de l'anglais "Metal Oxyde Semiconductor" - métal oxyde semiconducteur) formé dans et/ou sur une portion de couche semiconductrice, par exemple en diamant.

Bien que l'on cherche généralement à diminuer la résistance à l'état passant des composants d'un circuit de sorte à limiter les pertes et la consommation, dans le dispositif DEV2, le circuit CTRL2 augmente la résistance à l'état passant d'un ou plusieurs composants Ti pour éviter que le paramètre des branches Bi comprenant ces composants Ti continue d'augmenter de la manière décrite en relation avec la figure 1, du fait du coefficient négatif de variation de la résistance à l'état passant des composants Ti avec la température. Même si la résistance à l'état passant d'un ou plusieurs composants Ti est augmentée cela permet un équilibrage des contraintes entre les composants Ti, ce qui permet, par exemple, une augmentation de leur durée de vie. Par exemple, augmenter la résistance à l'état passant d'un composant Ti, par exemple en moyenne sur une durée D ou sur plusieurs durées D données, permet de réduire la température, par exemple en moyenne sur cette durée D ou sur ces plusieurs durées D, et la température d'un tel composant Ti influe directement sur sa durée de vie, par exemple réduit sa durée de vie lorsque la température augmente.

Selon un mode de réalisation, la plage de valeurs qui est commune à toutes les branches, et dans laquelle le circuit CTRL2 maintient la valeur du paramètre pour chaque branche en modulant les signaux de commande cmdi, est déterminée à partir d'une valeur de référence valref.

Par exemple, la plage de valeurs partagée entre les branches Bi est définie par une borne inférieure égale à valref moins un pourcentage donné de la valeur valref, et une borne supérieure égale à valref plus un pourcentage donné de cette valeur valref.

A titre d'exemple alternatif, la plage de valeurs partagée entre les branches Bi ne comprend qu'une seule valeur, à savoir la valeur valref. Dans ce cas, le circuit CTRL2 commande l'état passant des composants Ti de sorte que le paramètre soit égale à la valeur valref dans chacune des branches Bi.

A titre d'autre exemple alternatif, la plage de valeurs partagée entre les branches Bi s'étend d'une valeur nulle à la valeur valref, ou d'une valeur nulle à la valeur valref plus un pourcentage donné de cette valeur valref.

De manière optionnelle, la borne supérieure et/ou la borne inférieure de la plage de valeurs est en partie déterminée par la valeur valref et, en outre, en partie déterminée par une valeur minimale et/ou une valeur maximale que peuvent prendre chacun des signaux cmdi.

La valeur valref peut être une valeur prédéterminée par le fonctionnement désiré du circuit DEV2. Par exemple, dans le cas où le paramètre observé est le courant Ii dans chaque branche, la valeur valref est déterminée par le courant I que le composant COMP2 doit laisser circuler entre ses bornes 100 et 102 lorsque les composants Ti sont à l'état passants, et la valeur valref est, par exemple, égale à I/N.

Plutôt que d'être une valeur prédéfinie, la valeur valref peut être une valeur calculée, par exemple par le circuit CTRL2, à partir des valeurs du paramètre mesurées dans les branches Bi. Par exemple, la valeur valref est égale à la moyenne des valeurs mesurées dans les branches Bi. Par exemple, lorsque le paramètre mesuré est la température dans chaque branche Bi, donc dans chaque composant Ti, la valeur valref est déterminée par valeur moyenne des températures mesurées.

De préférence, lorsque le paramètre observé dans chaque branche Bi augmente quand la résistance à l'état passant du composant Ti de la branche diminue, par exemple suite à une augmentation de la température de la branche Bi, le circuit CTRL2 est configuré pour augmenter la résistance à l'état passant du composant Ti de la branche Bi lorsque la valeur du paramètre mesurée pour cette branche Bi augmente.

La mise en œuvre de l'asservissement de la résistance à l'état passant de chaque composant Ti par le circuit CTRL2 de sorte qu'un paramètre observé ait, dans chaque branche Bi et pendant une durée D où le composant COMP2 est passant, une valeur comprise dans une plage de valeurs commune à toutes les branches Bi, est à la portée de la personne du métier à partir des indications fonctionnelles données ci-dessus.

Dans le dispositif DEV2 ci-dessus, la modulation de la durée du premier état de chaque signal cmdi par rapport à une durée D qui est mise en œuvre par le circuit CTRL2 peut être mise en œuvre à chaque durée D indiquée par le signal ON.

En variante, la modulation de la durée du premier état de chaque signal cmdi par rapport à une durée D correspondante n'est mise en œuvre par le circuit CTRL2 que pour seulement certaines des durées D indiquées par le signal ON.

Différentes façons de moduler la durée du premier état d'un signal cmdi par rapport à une durée D correspondante indiquée par le signal ON peuvent être envisagées.

Selon un mode de réalisation, le circuit de commande est configuré, pendant une durée D, et pour chaque branche Bi, pour moduler la durée du premier état du signal de commande cmdi du composant Ti de cette branche Bi en forçant périodiquement le deuxième état du signal de commande cmdi pendant une durée donnée. De préférence, pendant une durée D, lorsqu'un signal de commande cmdi est par défaut à son premier état et est forcé de manière périodique à son deuxième état pendant une durée donnée, cela correspond à une modulation en largeur d'impulsion (PWM de l'anglais "Pulse Width Modulation"), ou, dit autrement, la durée donnée périodique de forçage du signal cmdi à son deuxième état est déterminé par modulation en largeur d'impulsion, par exemple sur la base d'un écart entre la valeur du paramètre mesuré dans la branche Bi et de la valeur valref du paramètre. A titre d'exemple, la durée périodique de forçage du signal cmdi à son deuxième état peut être nulle, par exemple quand l'écart entre la valeur du paramètre mesuré dans la branche Bi et la valeur valref est en dessous d'un seuil ou est, par exemple, nul. A titre d'exemple, la durée périodique de forçage du signal cmdi à son deuxième état peut être nulle quand le signal cmdi commande le composant Ti d'une branche Bi faisant partie du sous-ensemble de branches Bi où le circuit CTRL2 est configuré pour forcer une modulation nulle de la durée d'état passant des composants Ti du sous-ensemble par rapport à chaque durée D. A titre d'exemple, à chaque durée D, lorsque la durée périodique de forçage d'un signal cmdi à son deuxième état n'est pas nulle, par exemple du fait que l'écart entre la valeur du paramètre mesurée pour la branche Bi et la valeur de référence dépasse un seuil, par exemple sort de la plage de valeurs dans laquelle on cherche à maintenir le paramètre, la valeur de cette durée périodique de forçage du signal cmdi à son deuxième état est :
- constante et fixée par l'utilisateur ; ou
- est variable et déterminée par l'écart entre la valeur du paramètre mesurée pour cette branche Bi et la valeur de référence, par exemple en utilisant une table de correspondance entre les valeurs de l'écart et les valeurs de la durée périodique de forçage ou en utilisant une boucle de régulation prenant en entrée la valeur de l'écart et fournissant en sortie la valeur de la durée périodique de forçage, une telle boucle de régulation comprenant, par exemple, un régulateur proportionnel-intégral.

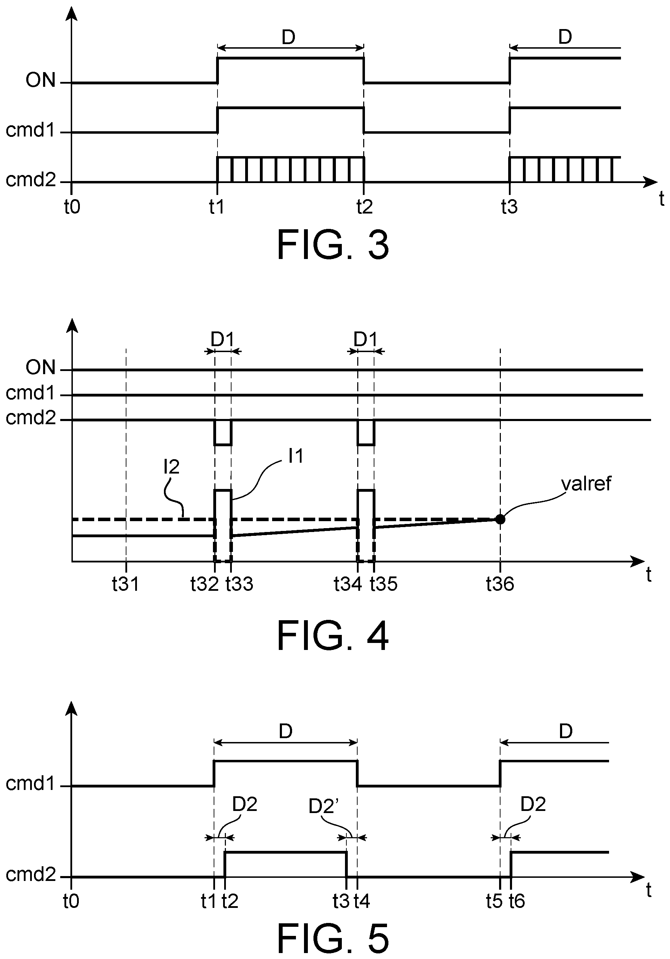

La figure 3 illustre un mode de commande où, pendant chaque durée D indiquée par le signal ON, dans chaque branche Bi, le signal cmdi est par défaut à son premier état et est forcé de manière périodique à son deuxième état, par exemple pendant une durée déterminée par modulation de largeur d'impulsion. Dans cet exemple, le signal ON est un signal binaire dans un premier état pour indiquer une durée D, et dans un deuxième état pour indiquer que le composant COMP2 doit être à l'état bloqué.

Plus particulièrement, la figure 3 représente, dans un exemple de dispositif DEV2 où N est égal à 2, l'évolution du signal ON et des signaux cmdi, c'est à dire cmd1 et cmd2 dans cet exemple. Dans cet exemple, le signal ON est un signal binaire. Dans cet exemple, le premier état, respectivement le deuxième état, du signal ON commandant l'état passant, respectivement l'état bloqué, du composant COMP2 est un état haut, respectivement un état bas. Dans cet exemple, pour chaque signal cmdi, le premier état, respectivement le deuxième état, commandant le composant Ti à l'état passant, respectivement à l'état bloqué, est l'état haut, respectivement l'état bas, du signal cmdi.

A un instant t0, le signal ON est dans son deuxième état (COMP2 bloqué). Les signaux cmdi sont donc dans leurs deuxièmes états également (Ti bloqués).

A un instant suivant t1, le signal ON commute à son premier état (COMP2 passant) pour une durée D. Chaque signal cmdi commute alors à son premier état (Ti passant).

Dans cet exemple, le paramètre mesuré est le courant Ii dans chaque branche Bi. En outre, dans cet exemple, à l'instant t1, le courant I2 dans la branche B2 est supérieur au courant I1 dans la branche B1, ce qui indique que la résistance à l'état passant Ron2 est plus faible que la résistance Ron1.

Ainsi, à partir de l'instant t1, le circuit CTRL2 force de manière périodique que le signal cmd2 à son état bas pendant une durée D1. A titre d'exemple, en figure 3, l'écart entre la valeur mesurée du courant I1 et la valeur de référence valref du courant Ii dans chaque branche est tel que, à partir de l'instant t1, le circuit CTRL2 force de manière périodique le signal cmd1 à son deuxième état pendant une durée qui est nulle, d'où il résulte que le signal cmd1 reste à son premier état. A titre d'exemple alternatif, en figure 3, le circuit de commande CTRL2 est configuré pour que, à chaque durée D, pour chaque branche d'un sous-ensemble des branches B1 et B2, la modulation de la durée d'état passant du composant de cette branche par rapport à la durée D soit nulle, et seule la branche B1 fait partie de ce sous-ensemble dans l'exemple de la figure 3, d'où il résulte que le signal cmd1 reste à son premier état pendant exactement chaque durée D.

Cette modulation de la durée du premier état des signaux cmd1 et cmd2 se poursuit pendant toute la durée D du premier état du signal ON, jusqu'à un instant t2 postérieur à l'instant t1, où le signal ON est commuté à son deuxième état. A l'instant t3, les signaux cmdi sont donc commutés à leurs deuxièmes états.

A un instant suivant t3, le signal ON est de nouveau commuté à son premier état pour une nouvelle durée D.

Le fonctionnement à partir de l'instant t3 est alors le même que celui décrit entre entre les instants t1 et t2.

La figure 4 illustre, de manière plus détaillée, ce qui se passe après l'instant t3, pendant la durée D commençant avec l'instant t3.

A un instant t31 postérieur à l'instant t3, et pris pendant la durée D débutant à l'instant t3, le signal ON est dans son premier état (COMP2 passant), et les signaux cmd1 et cmd2 sont par défaut dans leur premier état (T1 et T2 passants).

Le courant I dans le composant COMP2 se réparti alors en deux courants I1 et I2 dans les branches respectives B1 et B2. Comme la résistance Ron2 est plus faible que la résistance Ron1, le courant I2 est supérieur au courant I1.

Pendant cette durée D, à un instant t32 postérieur à l'instant t31, le circuit force le signal cmd2 à son deuxième état pendant la durée D1 se terminant à un instant t32. Il en résulte que le courant I2 s'annule et que le courant I1 augmente. L'augmentation du courant I1 entraine un échauffement du composant T1, et donc une diminution de la résistance Ron1. A l'inverse, comme le courant I2 est nul, le composant T2 refroidit, ce qui entraine une augmentation de la résistance Ron2.

Ainsi, à l'instant t33, lorsque le signal cmd2 est commuté à son premier état et que les deux composants T1 et T2 se retrouvent simultanément passants, la résistance Ron2 a augmenté par rapport à l'instant t31, et la résistance Ron1 à diminué par rapport à l'instant t31. En raison de l'inertie thermique, cette augmentation de la résistance Ron2 et cette diminution de la résistance Ron1 se poursuivent jusqu'à un instant t34 suivant marquant le début d'une nouvelle durée D1. Comme la résistance Ron2 augmente et que la résistance Ron1 diminue à partir de l'instant t33, le courant I1 diminue et le courant I2 augmente, et les valeurs des courants I1 et I2 convergent vers la valeur valref.

Le fonctionnement décrit entre les instants t32 et t33 est répété entre l'instant t34 de début d'une nouvelle durée D1, et un instant suivant t35 de fin de cette durée D1.

Après l'instant t35, la résistance Ron1 a diminué par rapport à l'instant t34, et la résistance Ron2 a augmenté par rapport à l'instant t34. En raison de l'inertie thermique, cette augmentation de la résistance Ron2 et cette diminution de la résistance Ron1 se poursuivent après l'instant t35, jusqu'à un instant t36 où les courants I1 et I2 deviennent tous deux égaux à la valeur valref. A titre d'exemple, l'équilibrage entre les branches du paramètre dont on mesure la valeur dans chaque branche Bi peut se faire de manière plus lente que ce qui est illustré en figure 4, par exemple, s'étaler sur plusieurs périodes D, par exemple du fait que les constantes de temps thermiques sont bien plus longues, par exemple au moins dix fois plus longues, que les constantes de temps électriques.

Dans l'exemple décrit ci-dessus en relation avec les figures 3 et 4, le paramètre ayant sa valeur mesurée dans chaque branche Bi est le courant Ii. Toutefois, la personne du métier sera en mesure d'adapter cet exemple au cas où un autre paramètre dépendant de la résistance à l'état passant Roni des composants est utilisé, comme par exemple la température dans chaque branche Bi.

En outre, la personne du métier est mesure d'adapter l'exemple ci-dessus à des cas où le signal ON n'est pas un signal binaire, mais, par exemple, un signal indiquant, pour chaque durée D, un instant de début et de fin de cette durée D ou un signal indiquant une valeur de rapport cyclique lorsque le composant COMP2 est commandé en modulation de largeur d'impulsion.

Selon un autre mode de réalisation, le circuit de commande est configuré, pendant chaque durée D d'une pluralité de durée D, par exemple périodiques, et pour chaque branche Bi, pour moduler la durée du premier état du signal de commande cmdi du composant Ti de cette branche Bi en forçant le deuxième état du signal de commande cmdi pendant une durée donnée débutant avec cette durée D et/ou pendant une autre durée donnée se terminant avec cette durée D. De préférence, pendant chaque durée D, lorsqu'un signal de commande cmdi n'est pas forcé à son deuxième état, il est par défaut à son premier état. A titre d'exemple, pour chaque durée D, la durée pendant laquelle un signal cmdi est forcé à son deuxième état au début de la durée D et/ou la durée pendant laquelle un signal cmdi est forcé à son deuxième état à la fin de la durée D sont calculées (ou déterminées) en fonction de l'écart entre la valeur valref et une valeur vali mesurée, par exemple, lors d'une durée D précédente, et peuvent l'une et/ou l'autre être nulles, par exemple quand cet écart est en dessous d'un seuil, voir nul. A titre d'exemple alternatif ou complémentaire, le circuit CTRL2 est configuré, à chaque durée D et pour chaque branche Bi d'un sous-ensemble des branches Bi, pour que la durée pendant laquelle un signal cmdi est forcé à son deuxième état au début de la durée D et la durée pendant laquelle un signal cmdi est forcé à son deuxième état à la fin de la durée D soient nulles. A titre d'exemple, à chaque durée D, lorsque la durée pendant laquelle un signal cmdi est forcé à son deuxième état au début de la durée D n'est pas nulle, par exemple du fait que l'écart entre la valeur du paramètre mesurée pour la branche Bi et la valeur de référence dépasse un seuil, par exemple sort de la plage de valeurs dans laquelle on cherche à maintenir le paramètre, la valeur de cette durée pendant laquelle le signal cmdi est forcé à son deuxième état au début de la durée D est :
- constante et fixée par l'utilisateur ; ou
- est variable et déterminée par l'écart entre la valeur du paramètre mesurée pour cette branche Bi et la valeur de référence, par exemple en utilisant une table de correspondance entre les valeurs de l'écart et les valeurs de la durée pendant laquelle le signal cmdi est forcé à son deuxième état au début de la durée D, ou en utilisant une boucle de régulation prenant en entrée la valeur de l'écart et fournissant en sortie la valeur de la durée pendant laquelle le signal cmdi est forcé à son deuxième état au début de la durée D, une telle boucle de régulation comprenant, par exemple, un régulateur proportionnel-intégral. A titre d'exemple, à chaque durée D, lorsque la durée pendant laquelle un signal cmdi est forcé à son deuxième état à la fin de la durée D n'est pas nulle, par exemple du fait que l'écart entre la valeur du paramètre mesurée pour la branche Bi et la valeur de référence dépasse un seuil, par exemple sort de la plage de valeurs dans laquelle on cherche à maintenir le paramètre, la valeur de cette durée pendant laquelle le signal cmdi est forcé à son deuxième état à la fin de la durée D est :
- constante et fixée par l'utilisateur ; ou
- est variable et déterminée par l'écart entre la valeur du paramètre mesurée pour cette branche Bi et la valeur de référence, par exemple en utilisant une table de correspondance entre les valeurs de l'écart et les valeurs de la durée pendant laquelle le signal cmdi est forcé à son deuxième état à la fin de la durée D, ou en utilisant une boucle de régulation prenant en entrée la valeur de l'écart et fournissant en sortie la valeur de la durée pendant laquelle le signal cmdi est forcé à son deuxième état à la fin de la durée D, une telle boucle de régulation comprenant, par exemple, un régulateur proportionnel-intégral.

Cet autre mode de réalisation est analogue à la mise en œuvre de temps morts adaptatifs pour retarder la commutation au premier état d'un signal cmdi par au début de la durée D et/ou pour anticiper la commutation au deuxième état du signal cmdi par rapport à la fin de la durée D.

La figure 5 illustre un mode de commande où, pendant chacune d'une pluralité de durées D, de préférence périodiques, indiquées par le signal ON, dans chaque branche Bi, le signal cmdi est par défaut à son premier état et est forcé à son deuxième pendant une durée débutant avec la durée D, et pendant une autre durée se terminant avec cette durée D.

Plus particulièrement, la figure 5 représente, dans un exemple de dispositif DEV2 où N est égal à 2, l'évolution des signaux cmdi, c'est à dire cmd1 et cmd2 dans cet exemple. Dans cet exemple, pour chaque signal cmdi, le premier état, respectivement le deuxième état, commandant le composant Ti à l'état passant, respectivement à l'état bloqué, est l'état haut, respectivement l'état bas, du signal cmdi.

A un instant t0, le signal ON indique que le composant COMP2 doit être commandé à l'état bloqué. Les signaux cmdi sont donc dans leurs deuxièmes états également (Ti bloqués).

Le signal ON indique en outre qu'une durée D débute à un instant suivant t1 et se termine à un instant t4.

Dans cet exemple, le paramètre mesuré est le courant Ii dans chaque branche Bi. En outre, dans cet exemple, à l'instant t1, la ou les dernières mesures du courant Ii dans les branches Bi, par exemples un ou plusieurs mesures faites lors d'une ou plusieurs durées D antérieures à l'instant t1, indiquent une valeur val2 du courant I2 dans la branche B2 supérieure à la valeur val1 du courant I1 dans la branche B1, ce qui indique que la résistance à l'état passant Ron2 est plus faible que la résistance Ron1.

Dans cet exemple, à partir de l'instant t1, le circuit CTRL2 force le signal cmd2 à son état bas pendant une durée D2 se terminant à un instant postérieur t2. Dans cet exemple, à partir de l'instant t1, le circuit CTRL2 force le signal cmd1 à son deuxième état pendant une durée nulle dans l'exemple de la figure 5, et le signal cmd1 commute donc à son premier état à l'instant t1 correspondant au début la durée D. A titre d'exemple, cette durée est nulle en raison de la valeur de l'écart entre la valeur mesurée du courant I1 et la valeur de référence valref du courant Ii dans chaque branche, ou du fait que la branche B1 appartient à un sous-ensemble des branches B1 et B2 où, pour chaque branche du sous-ensemble, le circuit CTRL2 impose que la modulation de la durée d'état passant du composant de cette branche par rapport à la durée D soit nulle.

A l'instant t2, la durée D2 se termine, et le signal cmd2 commute à son premier état.

Avant l'instant t4, à un instant t3 compris entre les instants t2 et t4, le circuit CTRL2 force le signal cmd2 à son état bas pendant une durée D2' se terminant à l'instant t4 correspondant à la fin de la durée D, la durée D2' pouvant être égale à la durée D2. En outre, à un instant compris entre les instants t2 et t4, le circuit CTRL2 force le signal cmd1 à son deuxième état pendant une durée se terminant à l'instant t4 et qui est nulle dans l'exemple de la figure 5. A titre d'exemple, cette durée est nulle en raison de la valeur de l'écart entre la valeur mesurée du courant I1 et la valeur de référence valref du courant Ii dans chaque branche, ou du fait que la branche B1 appartient à un sous-ensemble des branches B1 et B2 où, pour chaque branche du sous-ensemble, le circuit CTRL2 impose que la modulation de la durée d'état passant du composant de cette branche par rapport à la durée D soit nulle.

A l'instant t4, les signaux cmdi qui ne sont pas déjà dans leurs deuxièmes états sont commutés à leurs deuxièmes états.

Le signal ON indique en outre qu'une nouvelle durée D débute à un instant t5 postérieur à l'instant t4. Le fonctionnement décrit en relation avec les instants t1 et t2 est répété aux instants respectifs t5 et t6, en mettant à jours les modulations des durées d'états passants de composants Ti par rapport à la durée D commençant à l'instant t5 sur la base des valeurs vali, par exemple mesurées lors de durée D débutant à l'instant t1. Par exemple, le circuit CTRL2 force le signal cmd2 à son deuxième état pendant une durée D2 débutant à l'instant t5 et se terminant à l'instant t6, cette durée D2 étant mise à jour par rapport à la durée D2 débutant à l'instant t1 et pouvant donc être différente de la durée D2 débutant à l'instant t1.

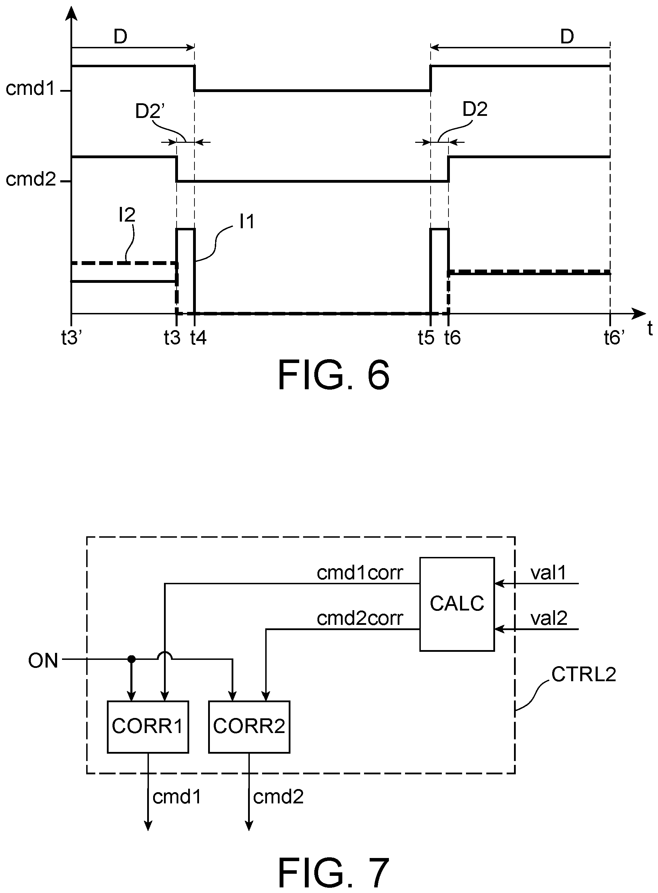

La figure 6 illustre, de manière plus détaillée, ce qui se passe entre un instant t3' compris entre les instants t2 et t3, et un t6' postérieur à l'instant t6.

Entre les instants t3' et t3, la résistance Ron1 est plus élevée que la résistance Ron2, d'où il résulte que le courant I2 est plus élevé que le courant I1.

Pendant la durée D2' entre les instants t3 et t4, le courant I2 est nul du fait que T2 est bloqué, et le courant I1 augmente. L'augmentation du courant I1 entraine un échauffement du composant T1, et donc une diminution de la résistance Ron1. A l'inverse, comme le courant I2 est nul, le composant T2 refroidit.

De manière similaire, pendant la durée D2 entre les instants t5 et t6, le courant I2 est nul du fait que T2 est bloqué, le courant I1 augmente, et l'augmentation du courant I1 entraine un échauffement du composant T1, et donc une diminution de la résistance Ron1, alors que le composant T2 refroidit.

Ainsi, après l'instant t6, par exemple à l'instant t6', la résistance Ron1 a une valeur plus faible qu'à l'instant t3', et, à l'inverse, la valeur de la résistance Ron2 est plus élevée qu'à l'instant t3'. Il en résulte que, à l'instant t6', le courant I1 est plus élevé qu'à l'instant t3', et que le courant I2 est plus faible qu'à l'instant t3'. Les courants I1 et I2 ont donc des valeurs plus proches l'une de l'autre à l'instant t6' qu'à l'instant t3'. Dit autrement, le fonctionnement décrit entre l'instant t3' et l'instant t6' permet de faire converger les valeurs des courants I1 et I2 vers la valeur valref.

Dans l'exemple décrit ci-dessus en relation avec les figures 5 et 6, le paramètre ayant sa valeur mesurée dans chaque branche Bi est le courant Ii. Dans un tel exemple, la modulation de la durée du premier état d'un signal cmdi par rapport à une durée D donnée est basée sur l'écart entre la valeur valref et une ou plusieurs valeurs vali mesurées lors d'une ou plusieurs durées D antérieures, à un ou des instants où le composant Ti est passant. La personne du métier sera en mesure d'adapter cet exemple au cas où un autre paramètre dépendant de la résistance à l'état passant Roni des composants est utilisé, comme par exemple la température dans chaque branche Bi. En outre, dans le cas où le paramètre mesuré est la température, la modulation de la durée du premier état d'un signal cmdi par rapport à une durée D donnée peut être basée sur l'écart entre la valeur valref et une ou plusieurs valeurs vali mesurées lors d'un ou plusieurs instants antérieurs à cette durée D, par exemple lors d'un ou plusieurs instants où le composant Ti est passant pendant une ou plusieurs durées D antérieures à cette durée D donnée.

De manière évidente pour la personne du métier à la lecture de la description faite ci-dessus, le mode de réalisation décrit en relation avec l'exemple des figures 5 et 6 peut être mis en œuvre à la condition que le signal ON indique plusieurs durées D successives séparées deux à deux par une durée D' où le composant COMP2 doit être commandé à l'état bloqué. Par exemple, le signal ON indique que les durées sont périodiques, par exemple car le composant COMP2 est commandé en modulation de largeur d'impulsion.

Le cas où les durées D sont périodiques, par exemple car le composant COMP2 est commandé en modulation de largeur d'impulsion, est ici considéré. Dans ce cas, le mode de réalisation où la durée du premier état de chaque signal cmdi est modulée de manière périodique pendant chaque durée D (figures 3 et 4) conduit à plus grand nombre de commutations des composants Ti, et ces commutations sont mises en œuvre à une fréquence plus élevée que la fréquence des durées D, par rapport au mode de réalisation où le premier état de chaque signal cmdi est modulée uniquement au début et/ou à la fin de chaque durée D (figures 5 et 6). Ainsi, le mode de réalisation où la modulation s'effectue uniquement au début et/ou à la fin de plusieurs durées D, permet une mise en œuvre plus simple, moins consommatrice, avec un vieillissement plus faible des composants Ti, et avec moins d'émissions électromagnétiques que le mode de réalisation où la modulation des signaux cmdi est périodique pendant chacune de ces plusieurs durées D.

A noter que dans d'autres modes de réalisation non illustrés, pour chaque signal cmdi, la modulation de la durée du premier état du signal cmdi pendant une durée D peut être mise en oeuvre différemment, par exemple en prévoyant que le circuit CTRL2 force, pendant la durée D, le signal cmdi à son deuxième état pendant une durée qui débute en retard par rapport au début de la durée D et qui se termine en avance par rapport à la fin de la durée D, par exemple pendant une durée qui se situe sensiblement au milieu de la durée D. A titre d'exemple, à chaque durée D, lorsque la durée pendant laquelle un signal cmdi est forcé à son deuxième état pendant la durée D n'est pas nulle, par exemple du fait que l'écart entre la valeur du paramètre mesurée pour la branche Bi et la valeur de référence dépasse un seuil, par exemple sort de la plage de valeurs dans laquelle on cherche à maintenir le paramètre, la valeur de cette durée pendant laquelle le signal cmdi est forcé à son deuxième état est :
- constante et fixée par l'utilisateur ; ou
- est variable et déterminée par l'écart entre la valeur du paramètre mesurée pour cette branche Bi et la valeur de référence, par exemple en utilisant une table de correspondance entre les valeurs de l'écart et les valeurs de la durée pendant laquelle le signal cmdi est forcé à son deuxième état à la fin de la durée D, ou en utilisant une boucle de régulation prenant en entrée la valeur de l'écart et fournissant en sortie la valeur de la durée pendant laquelle le signal cmdi est forcé à son deuxième état à la fin de la durée D, une telle boucle de régulation comprenant, par exemple, un régulateur proportionnel-intégral. Plus généralement, lorsqu'une modulation non nulle est appliquée, pendant une durée D, à la durée du premier état d'un signal cmdi qui est alors strictement inférieure à la durée D, la valeur de la modulation, c'est à dire de la ou des durées pendant lesquelles le signal cmdi est forcé à son deuxième état pendant la durée D, est soit constante et fixée par l'utilisateur, soit variable et déterminée par l'écart entre la valeur mesurée du paramètre pour branche Bi et la valeur de référence du paramètre.

Par rapport au cas où, pendant une durée D et pour chaque branche Bi, la durée du premier état du signal cmdi du composant Ti de la branche Bi est modulée en forçant le deuxième état du signal cmdi pendant une durée donnée débutant avec cette durée D et/ou pendant une autre durée donnée se terminant avec cette durée D, la modulation de la durée premier état du signal cmdi en forçant le deuxième état du signal cmdi pendant une durée qui débute en retard par rapport au début de la durée D et qui se termine en avance par rapport à la fin de la durée D présente l'avantage que les contraintes en commutation sont réparties équitablement entre tous les composants Ti en parallèle étant donné qu'ils commutent en même temps.

En outre, par rapport au cas où, pendant chaque durée D, et pour chaque branche Bi, la durée du premier état du signal cmdi du composant Ti de la branche est modulée en forçant périodiquement le deuxième état du signal de commande cmdi pendant une durée donnée, la modulation de la durée premier état du signal cmdi en forçant le deuxième état du signal cmdi pendant une durée qui débute en retard par rapport au début de la durée D et qui se termine en avance par rapport à la fin de la durée D présente l'avantage d'avoir des contraintes en fréquence plus faibles sur le circuit fournissant le signal cmdi, du fait du nombre plus faible de commutations du signal cmdi par durée D.

Divers exemples de mode de réalisation d'un dispositif DEV2 ont été décrits. A titre d'exemple, le composant COMP2 de ce dispositif DEV2 peut être utilisé dans un système électronique plus complexe comme, par exemple, un convertisseur de tension, un onduleur ou un relai statique. Par exemple, dans un système électronique comprenant le dispositif DEV2, le composant COMP2 du dispositif DEV2 est utilisé comme un interrupteur entre ses deux bornes 100 et 102, l'état passant ou bloqué de cet interrupteur COMP2 étant commandé par le signal ON.

Selon un mode de réalisation, le dispositif DEV2 est mis en œuvre dans un onduleur et le composant COMP2 correspond à un interrupteur de commutation de l'onduleur.

Selon un mode de réalisation, le dispositif DEV2 met en œuvre un interrupteur de commutation d'un onduleur, et chaque composant Ti est :
- un transistor MOS ayant une diode de corps ("body diode" en anglais) connectée en antiparallèle entre ses bornes de conduction (drain et source), c'est à dire que la diode de corps à son anode du côté de la source, ou
- un transistor MOS ayant une diode connectée en antiparallèle entre ses bornes de conduction (drain et source), c'est à dire que la diode de corps à son anode du côté de la source, ou
- un transistor bipolaire à grille isolé (IGBT de l'anglais "Insulated Gate Bipolar Transistor") ayant une diode connectée en antiparallèle entre ses bornes de conduction (collecteur et émetteur), c'est à dire que la diode à son anode du côté de l'émetteur, ou
- plus généralement, un interrupteur bidirectionnel en courant à l'état passant, mais unidirectionnel en courant à l'état bloqué, c'est à dire que l'interrupteur est configuré pour laisser passer un courant non nul entre ses bornes de conduction, uniquement dans un sens, lorsque cet interrupteur est commandé à l'état bloqué, par exemple via une diode de roue libre ("freewheel diode" en anglais) de l'interrupteur.

A titre d'exemple, un interrupteur bidirectionnel en courant à l'état passant et unidirectionnel en courant à l'état bloqué est configuré pour que :
- lorsque l'interrupteur est commandé à l'état passant, un courant positif puisse circuler d'une première borne de conduction à une deuxième borne de conduction de l'interrupteur, et de la deuxième borne de conduction à la première de conduction de l'interrupteur ; et
- lorsque l'interrupteur est commandé à l'état bloqué, un courant positif puisse circuler de la première borne de conduction à la deuxième borne de conduction uniquement, mais pas de la deuxième borne de conduction à la première borne de conduction. A titre d'exemple, dans un tel interrupteur, lorsqu'un courant positif circule de la première borne de conduction à la deuxième borne de conduction de l'interrupteur, la résistance vue par ce courant est plus faible lorsque l'interrupteur est commandé à l'état passant que lorsque l'interrupteur est commandé à l'état bloqué.

A titre d'exemple, un interrupteur bidirectionnel en courant à l'état passant et unidirectionnel en courant à l'état bloqué peut aussi être vu comme un interrupteur permettant d'obtenir une fonction d'interrupteur bidirectionnelle en courant et unidirectionnelle en tension. A titre d'exemple, un interrupteur bidirectionnel en courant à l'état passant et unidirectionnel en courant à l'état bloqué peut aussi être vu comme un interrupteur apte à conduire un courant inverse même lorsqu'il est commandé à l'état bloqué (dans le quadrant III).

Dans un mode de réalisation où chaque composant Ti est un interrupteur bidirectionnel en courant à l'état passant et unidirectionnel en courant à l'état bloqué, on considère le cas où, à chaque durée D, la modulation du premier état de chaque signal cmdi est mise en œuvre en forçant ce signal cmdi à son deuxième état pendant une durée se terminant avec cette durée D. Dans ce cas, lorsque le composant COMP2 est commandé à l'état passant pendant la durée D et que le courant I entre les bornes 100 et 102 correspond à un courant positif circulant des deuxièmes bornes vers les premières bornes de conduction des interrupteurs Ti, lorsqu'un composant Ti est forcé à l'état bloqué avant la fin de la durée D, tout le courant Ii qui circulait dans la branche Bi correspondante se réparti entre les autres branches Bi où les interrupteurs Ti sont encore passants. Il en résulte que, à la fin de la durée D, lorsque les interrupteurs Ti encore commandés à l'état passant commute d'une commande d'état passant (cmdi dans le premier état) à une commande d'état bloqué (cmdi dans le deuxième état, ces interrupteurs Ti prennent l'intégralité des contraintes en commutation à la fin de la durée D. De manière similaire, lorsque le courant I circulant entre les bornes 100 et 102 correspond à un courant positif circulant des premières bornes vers les deuxièmes bornes de conduction des interrupteurs Ti, et lorsqu'un composant Ti est forcé à l'état bloqué avant la fin de la durée D, c'est à dire lorsque son signal cmdi commute au deuxième état commandant l'état bloqué de cet interrupteur Ti, tout le courant Ii qui circulait dans la branche Bi correspondante se réparti entre les autres branches Bi où les interrupteurs Ti sont encore passants. En effet, les interrupteurs Ti commandés à l'état passant ont une résistance plus faible que des interrupteurs Ti commandés à l'état bloqué, bien que ces interrupteurs Ti commandés à l'état bloqué soient aptes à laisser circuler un courant positif depuis leurs premières bornes vers leurs deuxièmes bornes, par exemple via des diodes de roue libre ou de corps de ces interrupteurs. Toutefois, à la fin de la durée D, lorsque les interrupteurs Ti encore commandés à l'état passant commute d'une commande d'état passant (cmdi dans le premier état) à une commande d'état bloqué (cmdi dans le deuxième état, et que tous les interrupteurs Ti se retrouvent commandés à l'état bloqué, le courant I peut continuer à circuler entre les bornes 100 et 102, et se reparti de manière équilibrée entre les branches Bi, et les contraintes en commutation se répartissent entre les branches. Dit autrement, à la fin de la durée D, lorsque les interrupteurs Ti encore commandés à l'état passant commute d'une commande d'état passant (cmdi dans le premier état) à une commande d'état bloqué (cmdi dans le deuxième état, ces interrupteurs ne subissent pas eux seuls les contraintes en commutation, ces dernières restant réparties entre les branches Bi. A titre d'exemple, le courant I changera de signe (ou s'annulera) et ne circulera plus dans les interrupteurs Ti tous commandés à l'état bloqué lorsqu'un autre interrupteur (non illustré) en série avec le composant COMP2 passe à l'état passant, par exemple après une période débutant avec la fin de la durée D pour éviter de court circuiter les extrémités d'un bras d'un onduleur comprenant le composant COMP2 et cet autre interrupteur.

Ce qui vient d'être décrit ci-dessus pour le cas où, à chaque durée D, la modulation du premier état de chaque signal cmdi est mise en œuvre en forçant ce signal cmdi à son deuxième état pendant une durée se terminant avec cette durée D (par exemple la durée D2' pour le signal cmd2 en figures 5 et 6) est vrai également dans le cas où, à chaque durée D, la modulation du premier état de chaque signal cmdi est mise en œuvre en forçant ce signal cmdi à son deuxième état pendant une durée débutant avec cette durée D (par exemple la durée D2 pour le signal cmd2 en figures 5 et 6).

Ainsi, selon un mode de réalisation où le dispositif DEV2 met en œuvre un interrupteur de commutation d'un onduleur et où chaque composant Ti est un interrupteur bidirectionnel en courant à l'état passant et unidirectionnel en courant à l'état bloqué, c'est à dire un interrupteur configuré, lorsqu'il est commandé à l'état bloqué, pour laisser circuler un courant positif uniquement depuis sa première borne de conduction vers sa deuxième borne de conduction, le circuit CTRL2 est configuré, pendant chaque durée D, et pour chaque branche Bi, pour moduler la durée du premier état du signal de commande cmdi du composant Ti de la branche Bi en forçant le deuxième état du signal cmdi pendant une durée débutant avec la durée D et/ou en forçant le deuxième état du signal de commande cmdi pendant une deuxième durée se terminant avec la durée D, uniquement si le courant I circulant entre les deux bornes 100 et 102 est un courant positif circulant dans un sens allant des premières bornes de conduction vers les deuxièmes bornes de conduction des composants Ti.

A titre d'exemple, dans un onduleur, le cas où le courant I circulant entre les bornes 100 et 102 du composant COMP2 est un courant positif circulant dans le sens allant des premières vers les deuxièmes bornes de conduction des interrupteurs Ti se produit pendant la moitié de chaque période du fondamentale du signal de sortie de l'onduleur. De préférence, le mode de réalisation où la durée du premier état du signal de commande cmdi du composant Ti de chaque branche Bi est modulée en forçant le deuxième état du signal cmdi pendant une durée débutant avec la durée D et/ou en forçant le deuxième état du signal de commande cmdi pendant une deuxième durée se terminant avec la durée D, uniquement si le courant I circulant entre les deux bornes 100 et 102 est un courant positif circulant dans un sens allant des premières vers les deuxièmes bornes de conduction des composants Ti, est mis en oeuvre si la période du fondamentale du signal de sortie de l'onduleur est inférieure, par exemple dix fois plus faible, que la constante de temps thermique du système.

La figure 7 représente un exemple d'un mode de réalisation plus détaillé du circuit CTRL2. Dans l'exemple de la figure 7, N est égal à 2.

Dans cet exemple, le circuit CTRL2 comprend un circuit de calcul CALC. Le circuit de calcul CALC reçoit les signaux vali de mesure du paramètre dans chacune des branches Bi, à savoir les signaux val1 et val2 dans cet exemple où N est égal à 2. Sur la base des mesures du paramètre dans les branches Bi, le circuit CALC détermine l'écart entre la valeur du paramètre dans chacune des branches Bi et la valeur valref de référence du paramètre. Dit autrement, à partir des signaux vali, donc des valeurs mesurées du paramètre, le circuit CALC détermine, ou détecte, s'il existe une dissymétrie de conduction entre les composants Ti.

A titre d'exemple, le circuit CALC peut être configuré pour calculer la valeur valref à partir des valeurs mesurées du paramètre dans les branches Bi.

Pour chaque branche Bi, le circuit CALC est configuré pour fournir un signal de correction de commande cmdicorr (cmd1corr et cmd2corr dans l'exemple de la figure 7). Ce signal cmdicorr indique comment, pendant une durée D indiquée par le signal ON, le signal cmdi doit être forcé à son deuxième état de sorte à ramener la valeur du paramètre dans la branche Bi dans la plage de valeur du paramètre qui est partagée par toutes les branches Bi. Dit autrement, le signal cmdicorr indique comment, pendant une durée D d'état passant du composant COMP2, la durée du premier état du signal cmdi doit être modulée pour réduire, voire annuler, une dissymétrie de conduction entre les composants Ti.

A titre d'exemple, chaque signal cmdicorr peut être un signal de type PWM ayant un rapport cyclique déterminé à partir de l'écart en la valeur du paramètre mesurée dans la branche Bi et la valeur valref, voire à partir des écarts entre les valeurs du paramètres mesurées dans les branches Bi.

A titre d'autre exemple, chaque signal cmdicorr peut être un signal indiquant une valeur d'une durée pendant laquelle, à partir du début d'une durée D, le signal cmdi doit être maintenu à son deuxième état et/ou une valeur d'une durée pendant laquelle, jusqu'à la fin d'une durée D, le signal cmdi doit être maintenu à son deuxième état.

Le circuit CTRL2 comprend en outre, pour chaque branche Bi, un circuit CORRi (CORR1 et CORR2 dans l'exemple de la figure 7). Chaque circuit CORRi est configuré pour recevoir le signal ON et le signal cmdicorr, et pour fournir le signal cmdi correspondant.

A titre d'exemple, lorsque chaque signal cmdicorr est un signal de type PWM et que le signal ON est un signal binaire, chaque circuit CORRi met en œuvre, lorsque le signal ON est dans son premier état, une fonction OU EXCLUSIF entre le signal ON et le signal cmdi, et le signal cmdi est déterminé par le résultat de cette opération booléenne.

A titre d'autre exemple, lorsque chaque signal cmdicorr est représentatif d'une valeur d'un temps mort de commutation, c'est à dire d'une valeur d'une durée pendant laquelle, à partir du début d'une durée D d'état passant du composant COMP2, le signal cmdi doit être maintenu à son deuxième état et/ou d'une valeur d'une durée pendant laquelle, jusqu'à la fin d'une durée D d'état passant du composant COMP2, le signal cmdi doit être maintenu à son deuxième état, chaque circuit CORRi peut être mis en œuvre par un circuit minuteur ("timer" en anglais). Dans ce cas, à titre d'exemple, le signal ON indique une valeur de rapport cyclique de la durée D périodique. Cela correspond, par exemple, à un cas où le composant COMP2 est commandé en modulation de largeur d'impulsion.

Dans les modes de réalisation et variantes décrits ci-dessus, chacune des branches Bi identiques connectées en parallèle comprend uniquement le composant semiconducteur Ti et le circuit de mesure MESi correspondant. Dans des variantes de réalisation non illustrées, chacune des branches identiques Bi peut en outre comprend un ou plusieurs autres éléments, par exemple connectés en série avec le composant Ti, par exemple une ou plusieurs résistances.

Dans les modes de réalisation et variantes décrits précédemment, le composant semiconducteur Ti ayant une résistance à l'état passant à coefficient négatif de variation avec la température présente un état passant et un état bloqué. La résistance à l'état passant du composant est alors la résistance du composant Ti, prise entre ses deux bornes de conduction, lorsque le composant est commandé à l'état passant.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la personne du métier est en mesure de prévoir d'autres mises en œuvre du circuit CTRL2 que celle décrite en relation avec la figure 7, à partir des indications fonctionnelles données ci-dessus. En outre, la présente description ne se limite pas aux exemples de modes de réalisation et variantes décrits où N est égal à 2 ou 3, mais s'applique à n'importe quelle valeur du nombre N supérieure ou égale à 3. Par ailleurs, le paramètre dont la valeur dépend de la résistance à l'état passant des composants Ti qui est évalué dans chaque branche Bi de sorte à maintenir, grâce aux signaux cmdi, sa valeur dans une plage de valeurs commune à toutes les branches ne se limite pas aux exemples donnés où ce paramètre est le courant Ii ou la température dans chaque branche Bi.

Enfin, la mise en œuvre pratique des modes de réalisation et variantes décrits est à la portée de la personne du métier à partir des indications fonctionnelles données ci-dessus.

## Revendications

1. Dispositif (DEV2) comprenant deux bornes (100 ; 102) et des branches (B1, B2, B3) identiques connectées en parallèle entre lesdites deux bornes, chaque branche comprenant :
- un composant semiconducteur (T1, T2, T3) ayant une borne de commande configurée pour recevoir un signal binaire de commande (cmd1, cmd2, cmd3) dans un premier état binaire pour commander l'état passant du composant entre des première et deuxième bornes de conduction du composant et dans un deuxième état binaire pour commander l'état bloqué du composant entre les première et deuxième bornes de conduction du composant, une résistance à l'état passant du composant ayant un coefficient négatif de variation avec la température ;
- un circuit de mesure (MES1, MES2, MES3) d'une valeur d'un paramètre de ladite branche,
dans lequel le dispositif comprend en outre un circuit de commande (CTRL2) configuré pour :
recevoir un premier signal (ON) indiquant une ou plusieurs premières durées (D) pendant lesquelles le dispositif doit être commandé à l'état passant entre ses deux bornes,
recevoir les valeurs mesurées (val1, val2, val3), et
pendant chaque première durée (D), pour fournir au composant de chaque branche le signal de commande dans le premier état binaire pendant une durée modulée par rapport à la première durée de sorte à maintenir la valeur du paramètre de ladite branche dans une plage de valeurs identique pour toutes les branches.

2. Dispositif selon la revendication 1, dans lequel, dans chaque branche (B1, B2, B3), pendant chaque première durée (D), le circuit de commande (CTRL2) est configuré pour que la durée modulée du premier état du signal de commande (cmd1, cmd2, cdm3) du composant (T1, T2, T3) de la branche soit inférieure ou égale à la première durée.

3. Dispositif selon la revendication 1 ou 2, dans lequel, dans chaque branche (B1, B2, B3), la valeur du paramètre est au moins en partie déterminée par la résistance à l'état passant du composant (T1, T2, T3) de ladite branche.

4. Dispositif selon l'une quelconque des revendications 1 à 3, dans lequel, dans chaque branche (B1, B2, B3), le composant semiconducteur (T1, T2, T3) est en série avec au moins un autre élément, par exemple une résistance.

5. Dispositif selon l'une quelconque des revendications 1 à 3, dans lequel chaque branche (B1, B2, B3) comprend uniquement ledit composant (T1, T2, T3) et le circuit de mesure (MES1, MES2, MES3).

6. Dispositif selon l'une quelconque des revendications 1 à 5, dans lequel le circuit de commande (CTRL2) est configuré, pour chaque branche (B1, B2, B3), pendant chaque première durée (D), pour moduler la durée du premier état du signal de commande (cmd1, cmd2, cmd3) de la branche indépendamment par rapport aux signaux de commande des autres branches.

7. Dispositif selon l'une quelconque des revendications 1 à 6, dans lequel le circuit de commande (CTRL2) est configuré, pour chaque branche, et pendant chaque première durée (D), pour diminuer la durée du premier état du signal de commande (cmd1, cmd2, cmd3) de la branche (B1, B2, B3) par rapport à la première durée (D) lorsque la valeur du paramètre mesurée pour cette branche est représentative d'une diminution de la résistance à l'état passant du composant.

8. Dispositif selon l'une quelconque des revendications 1 à 7, dans lequel ledit paramètre est un courant (I1, I2, I3) circulant dans la branche (B1, B2, B3), entre les bornes de conduction du composant (T1, T2, T3) de la branche, ou une température de ladite branche (B1, B2, B3).

9. Dispositif selon l'une quelconque des revendications 1 à 8, dans lequel le semiconducteur est du diamant.

10. Dispositif selon l'une quelconque des revendications 1 à 9, dans lequel le composant (T1, T2, T3) est un transistor MOS.

11. Dispositif selon l'une quelconque des revendications 1 à 10, dans lequel le circuit de commande (CTRL2) est configuré, à chaque première durée, pour que, dans chaque branche (B1) d'un sous-ensemble desdites branches (B1, B2), le composant (T1) de ladite branche (B1) soit commandé à l'état passant pendant exactement ladite première durée (D).

12. Dispositif selon l'une quelconque des revendications 1 à 11, dans lequel le circuit de commande (CTRL2) est configuré, pendant chaque première durée (D), et pour chaque branche (B1, B2, B3), pour moduler la durée du premier état du signal de commande (cmd1, cmd2, cmd3) du composant (T1, T2, T3) de la branche en forçant périodiquement le deuxième état du signal de commande pendant une deuxième durée (D1), de préférence selon une modulation en largeur d'impulsion.

13. Dispositif selon l'une quelconque des revendications 1 à 10, dans lequel le circuit de commande (CTRL2) est configuré, pendant chaque première durée (D), et pour chaque branche (B1, B2, B3), pour moduler la durée du premier état du signal de commande (cmd1, cmd2, cmd3) du composant (T1, T2, T3) de la branche en forçant le deuxième état du signal de commande pendant une deuxième durée (D2) débutant avec la première durée (D) et/ou en forçant le deuxième état du signal de commande pendant une troisième durée (D2') se terminant avec la première durée (D).

14. Système électronique comprenant un dispositif (DEV2) selon l'une quelconque des revendications 1 à 13, dans lequel lesdites branches (B1, B2, B3) mettent en œuvre, entre lesdites deux bornes (100 ; 102), un interrupteur du système.

15. Onduleur comprenant un dispositif selon la revendication 13, dans lequel :
le dispositif met en œuvre un interrupteur de commutation de l'onduleur ;
dans chaque branche (B1, B2, B3), le composant (T1, T2, T3) est un interrupteur configuré pour être bidirectionnel en courant à l'état passant et pour laisser passer un courant positif uniquement depuis une première borne de conduction du composant vers une deuxième borne de conduction du composant à l'état bloqué ;
le premier signal (ON) indique une pluralité de premières durées (D); et
le circuit de commande (CTRL2) est configuré, pendant chaque première durée (D), et pour chaque branche (B1, B2, B3), pour que la deuxième durée (D2) et/ou la troisième durée (D2') soient non nulles, uniquement si un courant (I) circulant entre les deux bornes (100 ; 102) est un courant positif circulant depuis les premières bornes de conduction des composants vers les deuxièmes bornes de conduction des composants.
